# EUROPÄISCHE PATENTSCHRIFT

(11) **EP 1 366 528 B1**
(45) Veröffentlichungstag und Bekanntmachung des Hinweises auf die Patenterteilung: **22.09.2004**
(21) Anmeldenummer: 02714053.2
(22) Anmeldetag: 22.02.2002
(51) Int. Cl.: H01L 43/08

(54) **STROMABHÄNGIGES RESISTIVES BAUELEMENT**
CURRENT-RESPONSIVE RESISTIVE COMPONENT
COMPOSANT RESISTIF DEPENDANT DU COURANT

(30) Priorität: 26.02.2001 DE 10110292
(43) Veröffentlichungstag der Anmeldung: 03.12.2003
(73) Patentinhaber: Leibniz-Institut für Festkörper- und Werkstoffforschung Dresden e.V., 01069 Dresden (DE)
(72) Erfinder: DÖRR, Kathrin, 01069 Dresden (DE); WALTER, Theresia, 01187 Dresden (DE); MÜLLER, Karl-Hartmut, 01187 Dresden (DE); NENKOV, Konstantin, 01069 Dresden (DE); SCHULTZ, Ludwig, 01328 Dresden (DE)
(74) Vertreter: Rauschenbach, Dieter, Dipl.-Ing. (FH)
(86) Internationale Anmeldenummer: PCT/DE2002/000657
(87) Internationale Veröffentlichungsnummer: WO 2002/069354

(56) Entgegenhaltungen:
- EP-A- 0 661 546
- EP-A- 0 864 538
- US-A- 4 737 757
- HELMOLT VON R ET AL: "GIANT NEGATIVE MAGNETORESISTANCE IN PEROVSKITELIKE LA2/3BA1/3MNOX FERROMAGNETIC FILMS" PHYSICAL REVIEW LETTERS, AMERICAN PHYSICAL SOCIETY, NEW YORK, US, Bd. 71, Nr. 14, 4. Oktober 1993 (1993-10-04), Seiten 2331-2333, XP000573821 ISSN: 0031-9007

## Beschreibung

### Technisches Gebiet

Die Erfindung betrifft ein Bauelement, das in Abhängigkeit von der Größe eines durch das Bauelement fließenden Stromes einen hohen oder einen niedrigen elektrischen Widerstand aufweist. Das Umschalten des Widerstands bei bestimmten Stromwerten tritt bei diesem Bauelement auch durch Einwirkung eines Magnetfeldes auf. Das Bauelement ist insbesondere als Schalter, Sensor oder Speicherelement verwendbar.

### Stand der Technik

Es sind bereits Bauelemente bekannt, bei denen magnetoresistive Effekte ausgenutzt werden und die sich für verschiedene Applikationen eignen, beispielsweise als Bewegungssensoren oder in Schreib-/Leseköpfen für magnetische Speichermedien. Dabei wird das Phänomen ausgenutzt, nach dem sich der Wert des ohmschen Widerstands magnetoresistiver Materialien in Abhängigkeit von der dort herrschenden Magnetisierung ändert. Diese Widerstandsänderung wird mit Hilfe üblicher Messmethoden ermittelt, beispielsweise indem die Änderung der Stärke des durch das Material fließenden Stromes erfasst wird.

So ist beispielsweise aus der US 5 134 533 eine auf diesem Effekt beruhende Sonde bekannt, die als Funktionselement eine Mehrschichtstruktur enthält, welche aus einer Stapelung von Schichten aus einem magnetischen Material, die durch Schichten aus einem unmagnetischen Material voneinander getrennt sind, besteht. Hierbei ist das magnetische Material aus einer mit den Metallen Fe, Co und Ni gebildeten Gruppe ausgewählt, während das unmagnetische Material unter den Metallen Mn, Cr, V und Ti ausgewählt ist. Bei dieser Sonde tritt unter der Einwirkung eines Magnetfeldes im magnetischen Material ein Übergang zwischen dem Zustand mit antiparalleler Ausrichtung der Magnetisierung benachbarter magnetischer Schichten und dem Zustand der parallelen Ausrichtung ein, der für einen Schalteffekt genutzt wird.

Es ist bekannt, leitfähige Manganoxide in Dünnschicht-Widerständen als Zwischenschicht zwischen einer resistiven Nitrid-Schicht und den elektrischen Kontakten einzusetzen, um die langzeitstabile Funktion des Widerstandselements bei erhöhten Temperaturen von etwa 150 °C zu verbessern (US-PS 4 737 757). Die Manganoxid-Schicht dient dabei der Vermeidung von Diffusionsprozessen zwischen der Nitrid-Schicht und den elektrischen Kontakten. Dieses Widerstandselement eignet sich allerdings nicht zum Umschalten des elektrischen Widerstands.

Es ist auch bereits ein Schichtsystem bekannt, bei dem zwei ferromagnetische Manganat-Schichten durch eine epitaktisch aufgewachsene und wenige Nanometer dicke Tunnelschicht aus einem Isolatormaterial getrennt sind (M. Viret et al., Europhys. Lett. 39 (5), pp. 545-549 (1997)). Die Manganatschichten sind hierbei 25 nm und 33 nm dick. An diesem Schichtsystem wurden beim Anlegen einer elektrischen Spannung zwischen den Manganat-Schichten unter der Einwirkung eines Magnetfeldes ebenfalls sprungartige Veränderungen des Widerstandes in der Richtung senkrecht zum Schichtsystem festgestellt, die auch hier im Übergang zwischen dem Zustand der antiparallelen Ausrichtung der Magnetisierung benachbarter magnetischer Schichten und dem Zustand der parallelen Ausrichtung ihre Ursache haben.

Weiterhin ist ein antiferromagnetisches isolierendes Manganoxid mit MnO₃ als Matrix bekannt, welches unter Einwirkung eines elektrischen Feldes oder eines elektrischen Stromes ausreichender Größe einen ferromagnetischen Metallzustand mit stark verringertem elektrischem Widerstand annimmt (EP 864 538 A1). Dabei handelt es sich beispielsweise um einen massiven Kristall aus Pr₁₋ₓCaₓMnO₃, bei dem unter Feld- oder Stromeinfluß ein metallischer Leitungskanal im Material erzeugt wird. Die erforderlichen Magnetfelder dafür haben die Größenordnung von 1 Tesla, und es müssen Spannungen um 100 V angelegt werden. Die Lage und Stabilität des Leitungspfades innerhalb der isolierenden Matrixphase hängt stark von der thermischen Vorgeschichte und von früheren Auslagerungen im Magnetfeld ab. Aus diesem Grund ist es auch schwierig, das für einen Sensor oder ein Speicherelement notwendige reproduzierbare Verhalten sicherzustellen.

### Darstellung der Erfindung

Der Erfindung liegt die Aufgabe zugrunde, ein einfach gestaltetes Bauelement zu schaffen, das in Abhängigkeit von der Größe eines durch das Bauelement fließenden Stromes einen hohen oder einen niedrigen elektrischen Widerstand aufweist und sich damit insbesondere als Schalter, Sensor oder Speicherelement einsetzen lässt.

Diese Aufgabe wird erfindungsgemäß mit einem Bauelement gelöst, das aus einer auf einem Substrat aufgebrachten, mit elektrischen Kontakten versehenen ≤ 4 nm dicken Manganatschicht besteht.

Die bei dem Bauelement verwendete erfindungsgemäß sehr dünne Manganat-Schicht weist in Abhängigkeit von der Größe eines Stromes zwei Zustände mit deutlich verschiedenem elektrischen Widerstand auf. Damit können, im Unterschied zu den bekannten Tunnelmagnetowiderstandselementen, die beiden Widerstandszustände durch Vorgabe der Stromgröße geschaltet werden. Das Bauelement weist darüber hinaus aber auch ein durch Anlegen eines Magnetfeldes beeinflusstes Schaltverhalten des elektrischen Widerstandes auf. Beide Effekte lassen sich auch vorteilhaft miteinander kombiniert applikativ nutzen.

Die konkrete Dicke der Manganat-Schicht ist in dem erfindungsgemäß angegebenen Dickenbereich bei der praktischen Umsetzung abhängig von den für die Schicht verwendeten Werkstoffen und der Mikrostruktur der Schicht. Dabei ist davon auszugehen, dass sich mit einer Dicke der Manganat-Schicht im Bereich von 1 nm bis 3 nm besonders günstige Eigenschaften erzielen lassen. Bei der Festlegung der Dicke ist noch zu beachten, dass bei zu groß gewählter Dicke die Manganat-Schicht unterhalb der ferromagnetischen Ordnungstemperatur T_{c} metallisch ist und eine lineare Abhängigkeit zwischen Strom und Spannung, also einen konstanten Widerstand zeigt. Andererseits besitzt eine zu dünne Manganat-Schicht Eigenschaften wie ein elektrischer Isolator mit extrem großen, der Messung praktisch nicht zugänglichen Widerstandswerten.

Vorteilhafterweise besteht die Manganat-Schicht aus einem Mangan-Perowskit oder einem Material der allgemeinen Formel R₁₋ₓAₓMnO_{3+d}, worin R für La, für ein Seltenerdelement, für Y oder für eine Mischung aus mehreren dieser Elemente steht. A ist ein nicht dreiwertiges Metall. Der Wert für d beträgt -0,1 bis 0,05. Als nicht dreiwertige Metalle kommen insbesondere Ca, Sr, Ba, Pb, Ce, Na oder K in Betracht.

Vorzugsweise besteht die Manganat-Schicht aus La_{0,7}Ca_{0,3}MnO₃ oder La_{0,7}Sr_{0,3}MnO₃.

Die Schicht kann auf einem epitaktischen einkristallinen Substrat angeordnet sein, das vorzugsweise aus NdGaO₃(110) bestehen kann.

Die Manganat-Schicht kann erfindungsgemäß auch strukturiert ausgebildet sein.

Zur Erzielung einer guten Lebensdauer und zur Erhaltung der Bauelementeeigenschaften kann die Manganat-Schicht mit einer Diffusionsbarriere-Schicht abgedeckt sein.

Zwischen der Manganat-Schicht und dem Substrat kann zweckmäßigerweise eine Haftvermittler- und/oder Diffusionsbarriere-Schicht angeordnet sein.

Vorteilhafterweise können auch mehrere Manganat-Schichten in Mehrschichtbauweise übereinandergestapelt sein, wobei zwischen den Manganat-Schichten jeweils eine 1 nm bis 5 nm dicke Isoliermaterial-Schicht angeordnet ist und mindestens eine der Manganat-Schichten mit elektrischen Kontakten versehen ist. Die Isoliermaterial-Schichten können dabei aus epitaktisch aufgewachsenem SrTiO₃, CaTiO₃, NdGaO₃ oder CeO₂ bestehen.

### Wege zur Ausführung der Erfindung

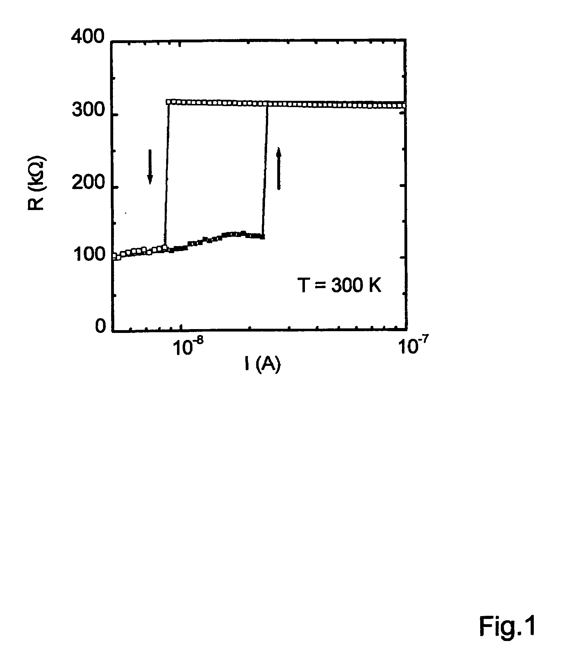

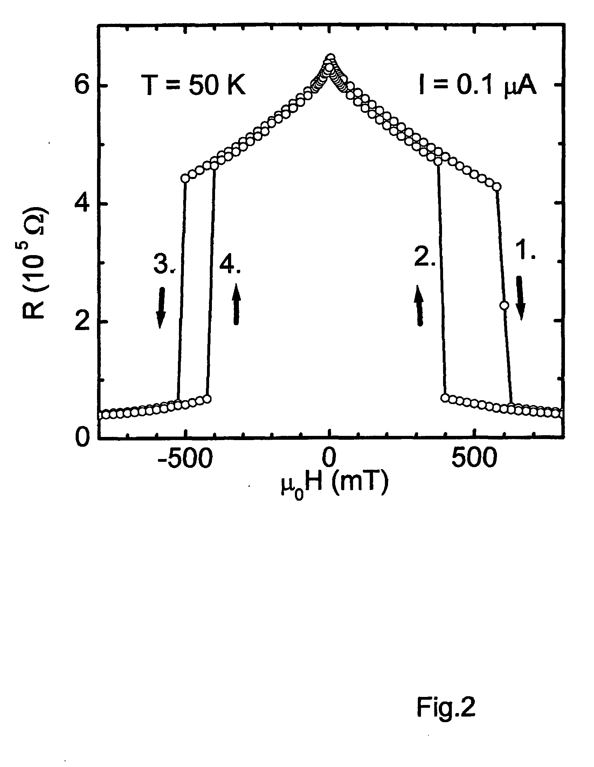

Die Erfindung ist nachstehend an Hand von zwei Ausführungsbeispielen näher erläutert. In den zugehörigen Zeichnungen Fig. 1 und Fig. 2 sind Diagramme gezeigt, die jeweils an den in den Beispielen 1 und 2 beschriebenen beiden Bauelementen gemessen worden sind. Das Diagramm 1 zeigt den Verlauf des elektrischen Widerstandes in Abhängigkeit von der Größe eines in das Bauelement eingespielten Stromes. Im Diagramm 2 ist der Verlauf des elektrischen Widerstandes in Abhängigkeit von einem äußeren Magnetfeld dargestellt.

### Beispiel 1

Dieses Beispiel betrifft ein Bauelement, bei dem auf einem 0,5 mm dicken einkristallinen Substrat 1 aus NdGaO₃(110) eine Manganat-Schicht aufgebracht ist. Die Manganat-Schicht besteht aus La_{0,7}Ca_{0,3}MnO₃ und weist eine Dicke von etwa 2 nm auf. Die Schicht ist unter Verwendung eines stöchiometrischen Targets mittels gepulster Laserdeposition in einer Atmosphäre mit 0,5 mbar Sauerstoff hergestellt worden. Die Manganat-Schicht ist mit zwei elektrischen Kontakten versehen, über die der Manganat-Schicht ein Strom zugeführt wird.

Beim Speisen der Stromanschlüsse mit unterschiedlichen Strömen ergibt sich bei einer Temperatur von 300 K das aus Fig. 1 ersichtliche Widerstandsverhalten der Manganat-Schicht. Der eingespeiste Strom ist dabei von kleinen zu großen Werten und wieder zurück verändert worden. Es zeigte sich ein hysteretisches Verhalten des Widerstandes, das durch unterschiedliche Stromwerte beim Schalten des Widerstands gekennzeichnet ist.

Das Widerstandsverhalten wurde im vorliegenden Beispiel aus den Spannungsabfallwerten über der Manganat-Schicht ermittelt, die an den Spannungsabgriffanschlüssen gemessen wurden.

Mit den vorliegenden Eigenschaften ist es möglich, das Bauelement als strom- und magnetfeldabhängigen Schalter oder Sensor oder als strom- und magnetfeldabhängiges Speicherelement zu verwenden.

### Beispiel 2

Dieses Beispiel betrifft ein Bauelement, bei dem auf einem 0,5 mm dicken einkristallinen Substrat aus SrTiO₃(100) 21 Manganat-Schichten mit 20 dazwischenliegenden Isolatormaterial-Schichten übereinandergestapelt sind. Die Manganat-Schichten bestehen aus La_{0,7}Sr_{0,3}MnO₃ und sind etwa 2 nm dick. Die Isolatormaterial-Schichten bestehen aus SrTiO₃ und sind ebenfalls etwa 2 nm dick. Die Mehrfachschicht wurde unter Verwendung stöchiometrischer Targets mittels gepulster Laserdeposition wie im Beispiel 1 hergestellt. Sie ist mit zwei elektrischen Kontakten versehen, über die den Manganat-Schichten ein Strom zugeführt wird.

Beim Einspeisen eines Stromes von 0,1 pA ergibt sich bei einer Temperatur von 50 K die in Fig.2 gezeigte Abhängigkeit des elektrischen Widerstands von einem parallel zu den Schichten angelegten Magnetfeld. Das Feld wurde dabei von 0 bis 1 Tesla und zurück erst in positiver und dann in negativer Feldrichtung verändert. Es zeigte sich ein hysteretisches Verhalten des Widerstands.

Das Widerstandsverhalten wurde wie im Beispiel 1 ermittelt.

Auch dieses Bauelement kann als strom- und magnetfeldabhängiger Schalter oder Sensor oder Speicherelement verwendet werden.

## Patentansprüche

1. Stromabhängiges resistives Bauelement, insbesondere verwendbar als Schalter, Sensor oder Speicherelement, **dadurch gekennzeichnet, dass** dieses aus einer auf einem Substrat aufgebrachten, mit elektrischen Kontakten versehenen ≤ 4 nm dicken Manganat-Schicht besteht.

2. Bauelement nach Anspruch 1, **dadurch gekennzeichnet, dass** die Manganat-Schicht eine Dicke von 1 nm bis 3 nm hat.

3. Bauelement nach Anspruch 1, **dadurch gekennzeichnet, dass** die Manganat-Schicht aus einem Mangan-Perowskit besteht.

4. Bauelement nach einem der Ansprüche 1 oder 3, **dadurch gekennzeichnet, dass** die Manganat-Schicht aus einem Material der allgemeinen Formel R₁₋ₓAₓMnO_{3+d} besteht, worin R für La, ein Seltenerdelement, Y oder eine Mischung aus mehreren dieser Elemente steht, A ein nicht dreiwertiges Metall ist und d = -0,1 bis 0,05 beträgt.

5. Bauelement nach Anspruch 4, **dadurch gekennzeichnet, dass** das nicht dreiwertige Metall Ca, Sr, Ba, Pb, Ce, Na oder K ist.

6. Bauelement nach Anspruch 1, **dadurch gekennzeichnet, dass** die Manganat-Schicht aus La_{0,7}Ca_{0,3}MnO₃ oder La_{0,7}Sr_{0,3}MnO₃ besteht.

7. Bauelement nach Anspruch 1, **dadurch gekennzeichnet, dass** die Manganat-Schicht auf einem epitaktischen einkristallinen Substrat, das vorzugsweise aus NdGaO₃ oder SrTiO₃ besteht, angeordnet ist.

8. Bauelement nach Anspruch 1, **dadurch gekennzeichnet, dass** die Manganat-Schicht strukturiert ausgebildet ist.

9. Bauelement nach Anspruch 1, **dadurch gekennzeichnet, dass** die Manganat-Schicht mit einer Diffusionsbarriere-Schicht abgedeckt ist.

10. Bauelement nach Anspruch 1, **dadurch gekennzeichnet, dass** zwischen der Manganat-Schicht und dem Substrat eine Haftvermittler- und/oder Diffusionsbarriere-Schicht angeordnet ist.

11. Bauelement nach einem der Ansprüche 1 bis 10, **dadurch gekennzeichnet, dass** mehrere Manganat-Schichten in Mehrschichtbauweise übereinandergestapelt sind, wobei zwischen den Manganat-Schichten jeweils eine 1 nm bis 5 nm dicke Isoliermaterial-Schicht angeordnet ist und mindestens eine der Manganat-Schichten mit elektrischen Kontakten versehen ist.

12. Bauelement nach Anspruch 11, **dadurch gekennzeichnet, dass** die Isoliermaterial-Schichten aus epitaktisch aufgewachsenem SrTiO₃, CaTiO₃, NdGaO₃ oder CeO₂ bestehen.

## Claims

1. Current-responsive resistive component, that can be used in particular as a switch, a sensor or a memory element, **characterized in that** this component comprises a ≤ 4 nm thick manganate layer which is applied to a substrate and is provided with electric contacts.

2. Component according to Claim 1, **characterized in that** the thickness of the manganate layer is from 1 nm to 3 nm.

3. Component according to Claim 1, **characterized in that** the manganate layer consists of a manganese perovskite.

4. Component according to either of Claims 1 or 3, **characterized in that** the manganate layer consists of a material of the general formula R₁₋ₓAₓMnO_{3+d}, where R stands for La, a rare earth element, Y or a mixture of a plurality of these elements, A is a metal which is not trivalent and d = -0.1 to 0.05.

5. Component according to Claim 4, **characterized in that** the metal which is not trivalent is Ca, Sr, Ba, Pb, Ce, Na or K.

6. Component according to Claim 1, **characterized in that** the manganate layer consists of La_{0.7}Ca_{0.3}MnO₃ or La_{0.7}Sr_{0.3}MnO₃.

7. Component according to Claim 1, **characterized in that** the manganate layer is arranged on an epitaxial single-crystalline substrate, which preferably consists of NdGaO₃ or SrTiO₃.

8. Component according to Claim 1, **characterized in that** the manganate layer is in structured form.

9. Component according to Claim 1, **characterized in that** the manganate layer is covered with a diffusion barrier layer.

10. Component according to Claim 1, **characterized in that** a bonding and/or diffusion barrier layer is arranged between the manganate layer and the substrate.

11. Component according to one of Claims 1 to 10, **characterized in that** a plurality of manganate layers are stacked on top of one another in a multilayer system, with in each case a 1 nm to 5 nm thick insulating material layer being arranged between the manganate layers, and at least one of the manganate layers being provided with electric contacts.

12. Component according to Claim 11, **characterized in that** the insulating material layers consist of epitaxially grown SrTiO₃, CaTiO₃, NdGaO₃ or CeO₂.

## Revendications

1. Composant résistif dont la résistance dépend du courant, apte à être utilisé en particulier comme commutateur, détecteur ou élément de mémoire, **caractérisé en ce qu'**il est constitué d'une couche de manganate appliquée sur un substrat, dotée de contacts électriques et d'une épaisseur ≤ 4 nm.

2. Composant selon la revendication 1, **caractérisé en ce que** la couche de manganate a une épaisseur de 1 nm à 3 nm.

3. Composant selon la revendication 1, **caractérisé en ce que** la couche de manganate est constituée de perovskite de manganèse.

4. Composant selon l'une des revendications 1 ou 3, **caractérisé en ce que** la couche de manganate est constituée d'un matériau de formule générale R₁₋ₓAₓMnO_{3+d} dans laquelle R représente La, un élément des terres rares, Y ou un mélange de plusieurs de ces éléments, A représente un métal non trivalent et d est compris entre -0,1 et 0,05.

5. Composant selon la revendication 4, **caractérisé en ce que** le métal non trivalent est Ca, Sr, Ba, Pb, Ce, Na ou K.

6. Composant selon la revendication 1, **caractérisé en ce que** la couche de manganate est constituée de La_{0,7}Ca_{0,3} MnO₃ ou de La_{0,7}Sr_{0,3} MnO₃.

7. Composant selon la revendication 1, **caractérisé en ce que** la couche de manganate est disposée sur un substrat épitaxique monocristallin, de préférence en NdGaO₃ ou en SrTiO₃.

8. Composant selon la revendication 1, **caractérisé en ce que** la couche de manganate est structurée.

9. Composant selon la revendication 1, **caractérisé en ce que** la couche de manganate est couverte par une couche de barrière à la diffusion.

10. Composant selon la revendication 1, **caractérisé en ce qu'**entre la couche de manganate et le substrat est disposée une couche d'adhérence et/ou une couche de barrière à la diffusion.

11. Composant selon l'une des revendications 1 à 10, **caractérisé en ce que** plusieurs couches de manganate sont superposées les unes aux autres, une couche de matériau isolant d'une épaisseur de 1 nm à 5 nm étant disposée à chaque pois entre les couches de manganate et au moins une des couches de manganate étant dotée de contacts électriques.

12. Composant selon la revendications 11, **caractérisé en ce que** les couches de matériau isolant sont constituées de SrTiO₃, de CaTiO₃, de NdGaO₃ ou de CeO₂ et sont obtenues par croissance épitaxique.
